# EUROPÄISCHE PATENTSCHRIFT

(11) **EP 1 252 363 B1**
(45) Veröffentlichungstag und Bekanntmachung des Hinweises auf die Patenterteilung: **10.09.2003**
(21) Anmeldenummer: 01915184.4
(22) Anmeldetag: 02.02.2001
(51) Int. Cl.: C23C 16/455

(54) **VORRICHTUNG UND VERFAHREN ZUM ABSCHEIDEN EINER ODER MEHRERER SCHICHTEN AUF EIN SUBSTRAT**
DEVICE AND METHOD FOR DEPOSITING ONE OR MORE LAYERS ONTO A SUBSTRATE
DISPOSITIF ET PROCEDE POUR DEPOSER UNE OU PLUSIEURS COUCHES SUR UN SUBSTRAT

(30) Priorität: 04.02.2000 DE 10004899
(43) Veröffentlichungstag der Anmeldung: 30.10.2002
(73) Patentinhaber: Aixtron AG, 52072 Aachen (DE)
(72) Erfinder: SCHUMACHER, Marcus, 50171 Kerpen (DE); STRZYZEWSKI, Piotr, 52134 Herzogenrath-Kohlscheid (DE); STRAUCH, Gerd, 52072 Aachen (DE); DAUELSBERG, Martin, 52064 Aachen (DE); JÜRGENSEN, Holger, 52072 Aachen (DE)
(74) Vertreter: Grundmann, Dirk, Dr.
(86) Internationale Anmeldenummer: EP0101103
(87) Internationale Veröffentlichungsnummer: WO01057289

(56) Entgegenhaltungen:
- EP-A- 0 821 084
- DE-A- 19 813 523
- US-A- 5 595 606
- US-A- 5 871 586
- US-A- 5 976 261

## Beschreibung

Die Erfindung betrifft ein Verfahren gemäß Gattungsbegriff des Anspruches 1 bzw. eine Vorrichtung gemäß Gattungsbegriff des Anspruches 6.

Ein derartiges Verfahren bzw. eine solche Vorrichtung ist aus der DE 198 13 523 C2 bekannt. Diese Schrift zeigt eine Vorrichtung zum Beschichten eines Substrates. Die Vorrichtung besitzt ein Gasversorgungssystem, welches nicht dargestellt aber erwähnt ist. Die vom Gasversorgungssystem bereitgestellten Gase werden mittels Zuleitung in die Reaktionskammer geleitet. Hierzu dient eine temperierte Gaseinlasseinheit. Die als Brausekopf ausgebildete Gaseinlasseinheit besitzt eine Vielzahl von Gasaustrittsöffnungen. Die Gasaustrittsöffnungen sind einer Platte der Gaseinlassheit zugeordnet, welche einem Suszeptor gegenüberliegt. Der Suszeptor kann geheizt werden. Die vom geheizten Suszeptor abgestrahlte Wärme heizt die Platte der Gaseinlasseinheit auf. Die Gaseinlasseinheit wird von einem Hohlkörper gebildet. Zwischen dem Reaktordeckel und dem Hohlkörper befindet sich ein Spalt, der mit einem Spülgas gespült wird. Durch Änderung der Gaszusammensetzung des Spülgases ist der Wärmewiderstand des Spaltes einstellbar. Der Spalt mündet in die Prozesskammer, so dass im Spalt derselbe Druck herrscht wie in der Prozesskammer.

Die US 5,871,586 befasst sich mit einer Vorrichtung zum Beschichten eines Substrates bzw. mit dem hierzu erforderlichen Verfahren. Diese Vorrichtung besitzt eine temperierte Gaseinlasseinheit. Die Gaseinlasseinheit besitzt ebenfalls die Form eines Duschkopfes mit einer eine Vielzahl von Gasaustrittsöffnungen aufweisenden Platte. Die Platte schließt die Prozesskammer nach oben ab. Auf der Rückseite der Platte befindet sich ein kühlmitteldurchströmtes Volumen. Als Kühlmittel gibt diese Schrift Wasser an. Rückwärtig dieser Kühlmittelkammer befinden sich zwei Gasvolumina, die jeweils mit einer zugehörigen Gasleitung mit einem Prozessgas versorgt werden, welches durch die Öffnung der Platte strömt.

Die US 5,595,606 zeigt eine CVD-Apparatur mit einer zwangsgekühlten Platte, durch welche das Gas in die Prozesskammer einströmt.

Bei der aus der WO 95/02711 bekannten Vorrichtung werden der oder die Prekursoren (Ausgangsstoffe) in "Form von Tröpfchen" einer nachgeschalteten, temperierten Verdampfungskammer zugeleitet und dort verdampft bzw. direkt durch Temperieren der Behälter des gasförmigen Produktes in den Reaktor eingebracht.

Hierdurch ergibt sich - gerade bei einer periodischen Einspritzung - nicht unter allen Betriebsbedingungen eine ausreichend homogene Verteilung der Reaktionsgase in der Reaktorkammer.

Zudem werden die Reaktionsgase oft nicht mit einer optimalen Temperatur in die Reaktionskammer eingespritzt.

Entsprechendes gilt für die aus der US-PS 5,554,220 bekannte Vorrichtung zur Kondensationsbeschichtung.

Der Erfindung liegt die Aufgabe zugrunde, eine gattungsgemäße Vorrichtung dahingehend weiterzubilden, dass Fehler durch Inhomogenitäten in den Temperaturen vermieden und damit bessere Schichten abgeschieden werden.

Gelöst wird die Aufgabe durch das in Anspruch 1 angegebene Verfahren bzw. durch die im Anspruch 6 angegebene Vorrichtung.

Das oder die Reaktionsgase werden vor dem Eintritt in die Reaktionskammer in eine Gaseinlasseinheit eingelassen, die über eine Mehrzahl getrennter Gaswege, deren Zahl kleiner oder gleich der Zahl der verwendeten Reaktionsgase ist, sowie eine Vielzahl von Austrittsöffnungen verfügt, die so angeordnet sind, dass die verschiedenen Reaktionsgase gemittelt über die Substratabmessungen homogen, jedoch räumlich derart getrennt in die Reaktionskammer eintreten, dass sie im Wesentlichen nicht vor der Oberfläche des oder der Substrate miteinander reagieren. Dabei werden das oder die Reaktionsgase auf ihrem jeweiligen Gasweg durch die Gaseinlasseinheit temperiert, d. h. erwärmt oder gekühlt; insbesondere kann die Temperatur der Gase geregelt werden oder auf Temperatur gehalten werden. Derartige Gaseinlasseinheiten werden auch als Showerhead bezeichnet. Eine besonders einfache Einstellung und insbesondere Regelung der Temperatur der einzulassenden Gase erhält man dadurch, dass die Temperatur der einzelnen Gase durch Steuerung bzw. Regelung des horizontalen und/oder des vertikalen Temperaturgradienten in der Gaseinlasseinheit auf unterschiedliche Temperaturen gesteuert bzw. geregelt wird. Zusätzlich kann bei dem erfindungsgemäßen Verfahren der Volumenstrom der in die Gaseinlasseinheit eintretenden Gase gesteuert und insbesondere geregelt werden. Auch kann die Gaseinlasseinheit zum Einlassen wenigstens eines Trägergases und/oder eines Spülgases verwendet werden. Das erfindungsgemäße Verfahren zur Beschichtung wenigstens eines Substrates kann in einem CVD, MOCVD oder OVPD-Verfahren (Kondensationsbeschichtung) eingesetzt werden und insbesondere zur Herstellung zur zu der Gruppe oxidischer Materialien gehörender Perowskite oder geschichteter Perowskite wie z. B. BaSrTiO₃, PbZrTiO₃, SrBi₂Ta₂O₉ oder zur Herstellung organischer Schichten, insbesondere "small molecules" und Polymere für z. B. Dünnfilmbauelemente wie OLED's oder Solarzellen dienen. Der Reaktor zur Beschichtung eines Substrats weist ein Gasversorgungssystem, das mindestens zwei verschiedene Gase bzw. Gasgemische getrennt bereitstellt, eine Reaktionskammer, in der mindestens ein zu beschichtendes Substrat auf wenigstens einem beheizten oder gekühlten Suszeptor angeordnet ist, und wenigstens eine temperierte Gaseinlasseinheit (Showerhead) auf, die wenigstens zwei der Gase bzw. Gasgemische getrennt voneinander in die Reaktionskammer einläßt, und die eine Vielzahl von Gas-Austrittsöffnungen aufweist, die zu Gruppen zusammengefasst sind, deren Zahl der Zahl der getrennt einzulassenden Gase bzw. Gasgemische entspricht, wobei aus jeder Gruppe von Gas-Austrittsöffnungen eines der Gase bzw. Gasgemische in die Reaktionskammer austritt.

Die Temperierung der Gaseinlasseinheit erfolgt über ein oder mehrere einstellbare Wärmewiderstände, die eine Steuerung bzw. Regelung des Wärmeflusses von wärmeren Stellen zur Gaseinlasseinheit bzw. des Wärmeflusses von der Gaseinlasseinheit zu kälteren Stellen der Reaktionskammer erlauben. Damit erhält man eine einfach aufgebaute und dennoch leicht und präzise zu regelnde Gaseinlasseinheit.

Insbesondere ist es möglich, dass der oder die Suszeptoren und/oder das oder die Substrate direkt oder indirekt gekühlt bzw. beheizt sind, und der Wärmefluss von bzw. zu den Suszeptoren bzw. Substraten gesteuert bzw. geregelt wird.

Die in den Puffervolumen befindlichen Gase verbleiben ausreichend lange in der Gaseinlasseinheit, um in gewünschter Weise temperiert werden zu können. Die Ankoppelung über einen variablen Wärmewiderstand kann insbesondere durch ein Zwischenvolumen erfolgen, in dem sich mindestens ein Medium mit einstellbarem Druck befindet. Weiter ist es bevorzugt, wenn die Puffervolumen in Normalrichtung der beheizten oder gekühlten Platte übereinander in einem Gehäuse der Gaseinlasseinheit angeordnet sind. Durch diese Ausbildung erhält man in ihrer Temperatur gestaffelte Pufferspeicher, so dass es in einfacher Weise möglich ist, Gase gegebenenfalls auf unterschiedliche Temperaturen zu temperieren. Die in Normalrichtung radialsymmetrische Ausbildung des Gehäuses führt zu einer homogenen Temperaturverteilung in Radialrichtung. Wenn man in dem oder den Zwischenvolumina mehrere Medien unterschiedlicher thermischer Wärmeleitfähigkeit einsetzt, kann man in einfacher Weise den Wärmewiderstand einstellen. Eine besonders schnelle Steuerung bzw. Regelung erhält man, wenn man Medien als Gase oder Gasgemische einsetzt. Durch die Ausbildung, gemäß der das Zwischenvolumen gegenüber dem Raum abgedichtet ist, in dem das oder die Substrate angeordnet sind, wird der Gasfluss in der Reaktionskammer nicht gestört. Als Wärmequelle bzw. Wärmesenke können bevorzugt temperierte Teile des Reaktors verwendet werden. Insbesondere kann die temperierte Platte von dem oder den Substraten bzw. Suszeptoren durch Wärmeübertragung mittels Wärmestrahlung, Wärmeleitung etc. temperiert werden.

Zur Einstellung des radialen und/oder vertikalen Temperaturgradienten kann die Gaseinlasseinheit auf die unterschiedlichsten Arten aufgebaut sein, beispielsweise kann sie aus wenigstens einem Material bestehen und insbesondere als horizontale oder vertikale Mehrschichtstruktur aus einem oder mehreren unterschiedlichen Materialien ausgeführt sein. Dabei können innerhalb der Mehrschichtstruktur zur Temperierung Kanäle vorgesehen sein. Als Materialien können beispielsweise Aluminium, Edelstahl, Quarzglas und Keramik verwendet werden.

Ferner kann die Gaseinlasseinheit mindestens eine u.U. herausnehmbare Zwischenplatte aufweise, die zur Einstellung des vertikalen und/oder horizontalen Temperaturgradienten an einander gegenüberliegende Begrenzungswände der Gaseinlasseinheit thermisch angekoppelt ist und insbesondere die Puffervolumen begrenzen kann. Insbesondere kann die wenigstens eine Zwischenplatte mindestens eine Öffnung aufweisen. Ferner können wenigstens zwei der Zwischenplatten über thermische Brücken zur Einstellung des vertikalen, horizontalen und/oder radialen Wärmeflusses verbunden sein. Auch kann wenigstens eine der Zwischenplatten zur Gasumlenkung innerhalb der Gaseinlasseinheit dienen. Alternativ oder zusätzlich kann wenigstens eine der Zwischenplatten außerhalb der Gaseinlasseinheit angeordnet sein und als Prallplatte dienen.

Weiterhin können Röhrchen die Gas-Austrittsöffnungen, die in der beheizten Platte vorgesehen sind, mit den einzelnen Puffervolumen verbinden. Dabei ist es von Vorteil, wenn die Öffnungen in geeigneter Weise profiliert sind.

Die erfindungsgemäße Vorrichtung eignet sich insbesondere für die Herstellung von Schichten, bei zumindest ein Teil der Prozessgase aus festen oder flüssigen Vorläufern erzeugt wird. Weiterhin kann die Gaseinlasseinheit zusätzlich zu Prozessgasen wenigstens ein Trägergas und/oder ein Spülgas einleiten.

Ausführungsbeispiele der Erfindung werden nachfolgend anhand beigefügter Zeichnungen erläutert. Es zeigen:
- Figur 1: eine schematisierte Querschnittsdarstellung einer Vorrichtung gemäß der Erfindung,
- Figur 2: eine vergrößerte Ausschnittsdarstellung ebenfalls schematisiert der Gaseinlasseinheit,
- Figur 3: eine Darstellung gemäß Figur 2 in einer Modifikation,
- Figur 4: eine vergrößerte Darstellung der Platte der Gaseinlasseinheit,
- Figur 5: eine schaltbildartige Darstellung der technischen Wirkung der Puffervolumen,
- Figur 6: der Temperaturverlauf im Bereich der Puffervolumen,
- Figur 7: eine Darstellung gemäß Figur 1 eines weiteren Ausführungsbeispieles der Erfindung,
- Figur 8: eine Darstellung gemäß Figur 2 eines weiteren Ausführungsbeispieles, und
- Figur 9: eine Darstellung gemäß Figur 1 eines weiteren Ausführungsbeispieles.

Der dort grob schematisch dargestellte Reaktor besitzt einen Reaktormantel in Form der Wand 31. Von diesem Reaktormantel 31 wird ein Bodenkörper 32 des Reaktors umfasst. In dem Bodenkörper 32, welcher z.B. eine zylindrische Gestalt hat, liegt ein Suszeptor 14, welcher der Träger eines oder mehrerer Substrate 2 ist. Der Suszeptor 14 wird von unten mittels einer Heizung 16 geheizt. Anstelle der Heizung 16 kann aber auch eine Kühlung vorgesehen sein, um den Suszeptor 14 bspw. auf Raupentemperatur zu halten, damit sich auf dem auf dem Suszeptor 14 liegenden Substrat 2 eine Schicht aufgrund Kondensation bilden kann.

Oberhalb des Bodenkörpers 32 bzw. des Suszeptors 14 befindet sich ein von der Außenwelt gasdicht abgeschlossener Raum 1, der eine Reaktionskammer bildet. In die Reaktionskammer 1 werden mittels einer oberhalb des Suszeptors 14 angeordneten Gaseinlasseinheit 8 Gase 4, 5, 6 eingeleitet. Diese Gase sind oder beinhalten Reaktionsgase, welche bspw. auf dem Suszeptor kondensieren können. In einem anderen Verfahren können diese Gase jedoch auch in der Gasphase oder, was bevorzugt ist, auf der Substratoberfläche selbst chemisch miteinander reagieren, wobei die Substratoberfläche 2 mit dem Reaktionsprodukt dieser Reaktion beschichtet wird. Bei der Beschichtung kann es sich um Kristallwachstum handeln.

Das Schichtwachstum erfolgt meistens polykristallin. In speziellen Fällen kann das Schichtwachstum auch einkristallin erfolgen.

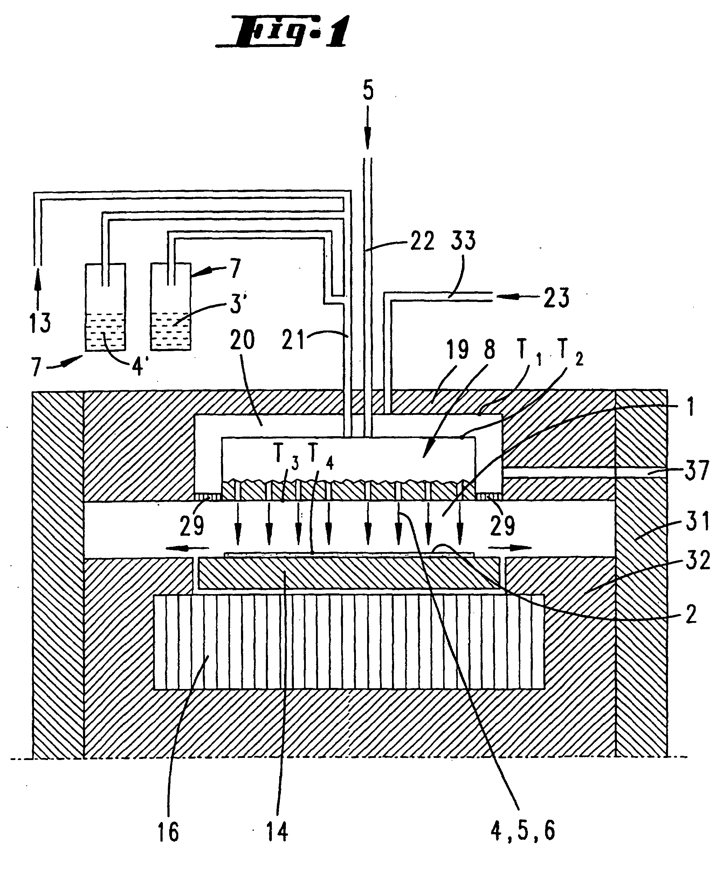

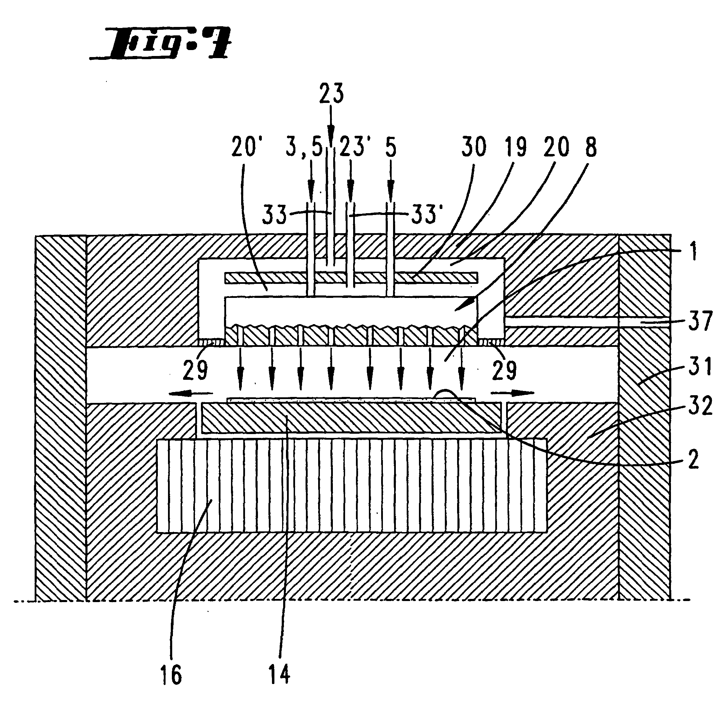

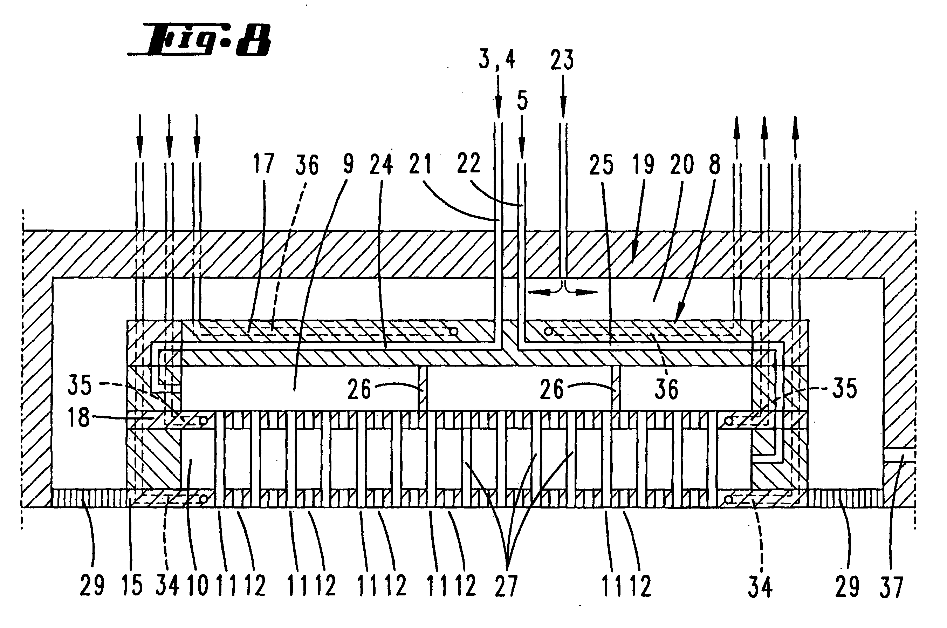

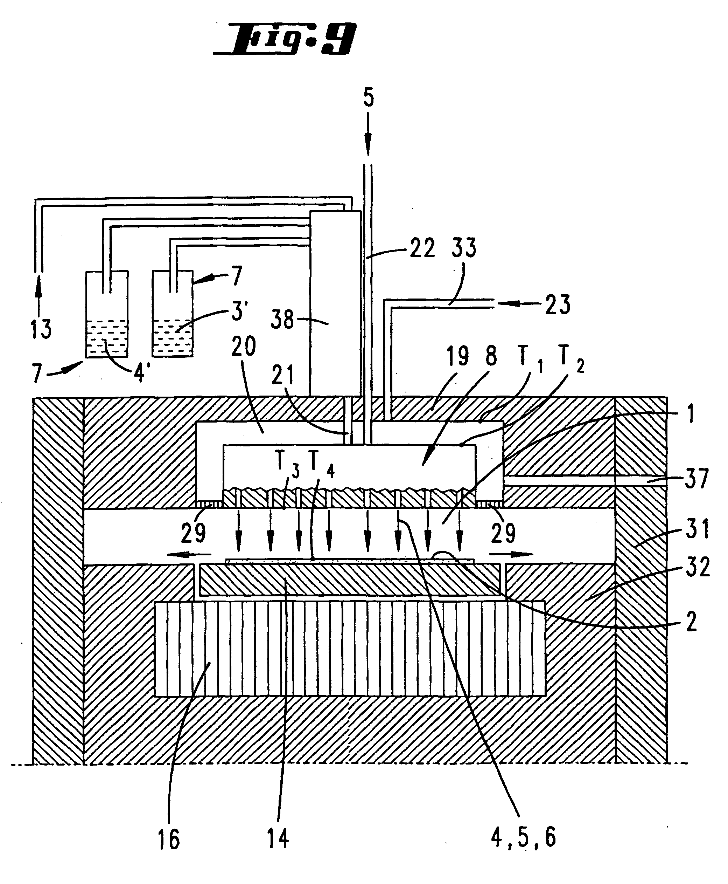

Die Gaseinlasseinheit 8 befindet sich in einer Höhlung des Reaktordeckels 19. Dieser Reaktordeckel 19 kann mittels einer nicht dargestellten Heizung bzw. einer ebenfalls nicht dargestellten Kühlung auf einer voreinstellbaren Temperatur gehalten werden. Die Gaseinlasseinheit 8 liegt in keinem Oberflächenkontakt zum Reaktordeckel 19. Vielmehr ist der Zwischenraum 20 zwischen dem Reaktordeckel 19 und der Außenoberfläche der Gaseinlasseinheit 8 gasgespült. In der Figur 1 bzw. der Figur 7 ist hierzu eine Spülgasleitung 33 dargestellt, in welche ein Spülgas 23 eingeleitet werden kann. Das Spülgas wird entsprechend des in der Reaktionskammer 1 stattfindenden Prozesses ausgewählt. Es handelt sich bevorzugt um ein Innertgas. Bei einem MOCVD-Prozess kann es Stickstoff oder eine Mischung von Stickstoff und Wasserstoff sein. Es kann aber auch Wasserstoff sein. Bei anderen Prozessen, bspw. bei den eingangs beschriebenen Oxidationsprozessen kann es auch eine Mischung von Edelgasen, bspw. eine Mischung von Helium und Argon sein. Bevorzugt handelt es sich um ein Gemisch von Gasen, welche stark voneinander abweichende Wärmeleiteigenschaften haben, so dass durch die Zusammensetzung der Mischung der beiden Gase der Wärmeleittransport vom Reaktordeckel 19 zur Gaseinlasseinheit 8 eingestellt werden kann. um sicherzustellen, dass der Wärmetransport über Wärmeleitung stattfindet, muss in dem Spaltraum 20 ein entsprechender Druck eingestellt werden. Liegt der Prozessdruck in der Reaktorkammer 1 unterhalb dieses Drucks, so wird der Spaltraum 20 von der Reaktionskammer 1 isoliert. Dies kann mittels Isolatoren 29 erfolgen, die gasdicht sind oder die Funktion einer Drossel übernehmen, so dass Gas aus dem Spaltraum 20 in die Reaktionskammer 1 einfließen kann. Der Spaltraum 20 kann auch eine eigene Gasableitung besitzen.
Die radial außen liegende Gasableitung der Reaktionskammer ist nicht dargestellt.

Durch den Spaltraum 20 ragen Zuleitungen 21, 22, durch welche Reaktionsgase 4, 5, 6 von einem Gasversorgungsorgan in die Gaseinlasseinheit 8 geleitet werden. Die Gase 3, 4 können in Dampfform gebrachte flüssige Ausgangsstoffe 4', 3' sein. Die Ausgangsstoffe 3', 4' können aber auch Feststoffe sein, die dann in die Reaktionsgase 3, 4 supplimieren. Die Feststoffe 3' bzw. Flüssigkeiten 4' werden in Behältern 7 aufbewahrt, die in der Figur 1 schematisch dargestellt sind. Die aus den Behältern 7 austretenden Gase 3, 4 gelangen über die Rohrleitung 21 durch den Reaktordeckel 19 in die Gaseinlasseinheit 8. In die Rohrleitung 21 kann zusätzlich ein Trägergas oder Spülgas 13 eingespeist werden.

Bei dem in der Figur 9 dargestellten Ausführungsbeispiel werden flüssige Ausgangsstoffe in einen temperierten Verdampfer 38 eingebracht. Die Ausgangsstoffe werden dort in bekannter Weise durch Wärmezufuhr entweder über Oberflächenkontakt oder bevorzugt durch Wärmeaufnahme aus dem heißen Trägergas verdampft und über die Gasleitung 21 in den Reaktor eingeleitet. Die Behälter 7, in denen sich die Ausgangsstoffe bei diesem Ausführungsbeispiel befinden, sind bevorzugt nicht beheizt.

Durch die Zuleitung 22 gelangt ein gasförmiger Ausgangsstoff 5 in die Gaseinlasseinheit 8.

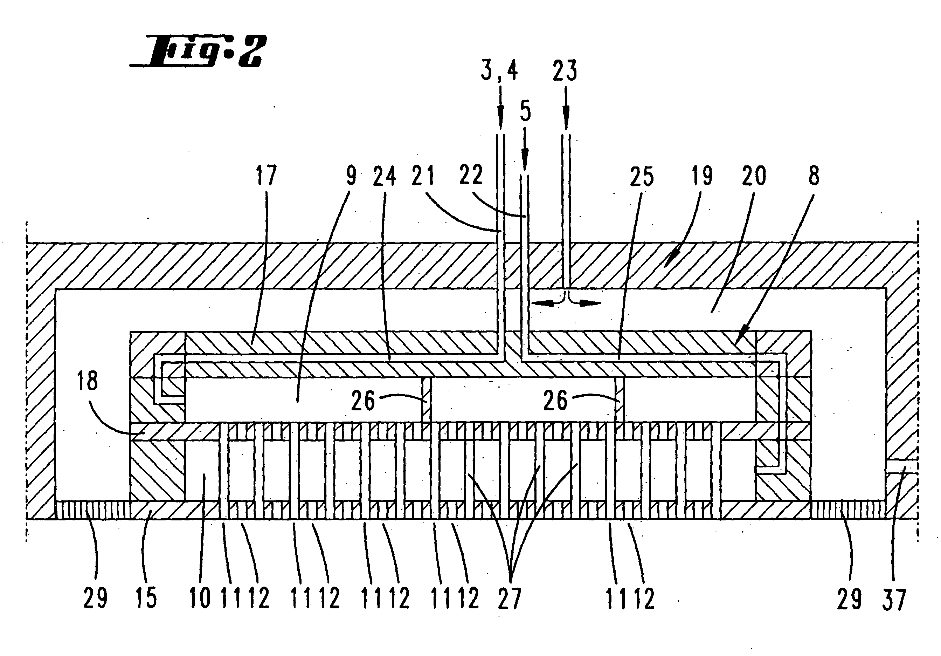

Zur Beschreibung der Gaseinlasseinheit 8 wird Bezug auf die Figur 2 genommen. Die Gaseinlasseinheit 8 besitzt eine kreisscheibenförmige Deckplatte 17, in welcher eine Vielzahl von sternförmig von der Mitte zum Rand hin verlaufende Kanäle 24, 25 angeordnet sind. Die Kanäle 24 sind mit der Rohrleitung 21 verbunden, durch welche die Reaktionsgase 3, 4 dem äußeren Rand einer oberen Kammer 9 zugeführt werden. Durch die Kanäle 25 fließt das durch die Zuleitung 22 zugeführte Reaktionsgas 5 in den Randbereich einer unterhalb der Kammer 9 liegenden Kammer 10. Die Hohlräume 9, 10 sind gasdicht voneinander getrennt und bilden Puffervolumen aus. Die Trennung der beiden Puffervolumen 9, 10 erfolgt durch eine Zwischenplatte 18, die ebenso wie die Deckplatte 17 aus Metall gefertigt sein kann. Zwischenplatte 18 und die Deckplatte 17 können durch wärmeleitende Brücken 26 miteinander verbunden sein. Lässt man die Brücken 26 weg, so erfolgt der Wärmetransport von der Deckplatte 17 zur Mittelplatte 18 durch Wärmeleitung der in den Puffervolumen 9 eingebrachten Reaktiönsgase 3, 4 bzw. des zusätzlichen Träger- oder Spülgases 13 sowie über den äußeren Randbereich der Gaseinhlasseinheit 8. Die Deckplatte 17 wird im Wesentlichen durch Wärmeleitung über den Spaltraum 20 aufgeheizt bzw. gekühlt.

Die Zwischenplatte 18 besitzt eine Vielzahl von Öffnungen, an welche sich Rohre 27 anschließen, die durch die Kammer 10 ragen bis in eine Lochplatte 15, welche die Bodenplatte der Gaseinlasseinheit 8 bilden. Zwischen der Platte 15 und der Zwischenplatte 18 befindet sich das Puffervolumen 10, in welches das Reaktionsgas 5 strömt. Im Zwischenraum zwischen den Rohren 27 bzw. deren Austrittsöffnungen 11 befinden sich Öffnungen 12, durch welche das im Puffervolumen 10 befindliche Reaktionsgas 5 austreten kann.

Die Platte 15 ist somit als Lochplatte ausgestaltet mit einer Vielzahl von eng nebeneinander liegenden Austrittsöffnungen 11, 12. Die den Rohren 27 zugeordneten Austrittsöffnungen 11 bilden eine erste Gruppe, aus denen ausschließlich die in dem Puffervolumen 9 befindlichen Reaktionsgase 4 und 5 austreten. Aus den der zweiten Gruppe zugeordneten Austrittsöffnungen 12, welche jeweils von den Austrittsöffnungen 11 benachbart sind, tritt das Reaktionsgas 5 aus, welches sich im Puffervolumen 10 befindet.

Die Drucke in den Puffervolumen 9, 10 sind in Bezug auf die Durchmesser und die Anzahl der Austrittsöffnungen 11, 12 so gewählt, dass über die gesamte Fläche der Platte 15 ein gleichmäßiges Strömungsprofil austritt. Die Höhe der Reaktionskammer 1 ist dabei so gewählt, dass sich die aus den Austrittsöffnungen 11, 12 austretenden Gasströme bis zum Substrat 2 vermischt haben.

Der Transport der Wärme von der Zwischenplatte 18 zur Platte 15 erfolgt durch Wärmeleitung. Die Wärmeleitung kann über die Rohre 27 erfolgen, wenn diese wärmeleitfähigem Material gefertigt sind. Die Wärmeleitung kann aber auch über das Gas erfolgen, welches sich im Puffervolumen 10 befindet. Sowie über den äußeren Rand der Gaseinlasseinheit 8.

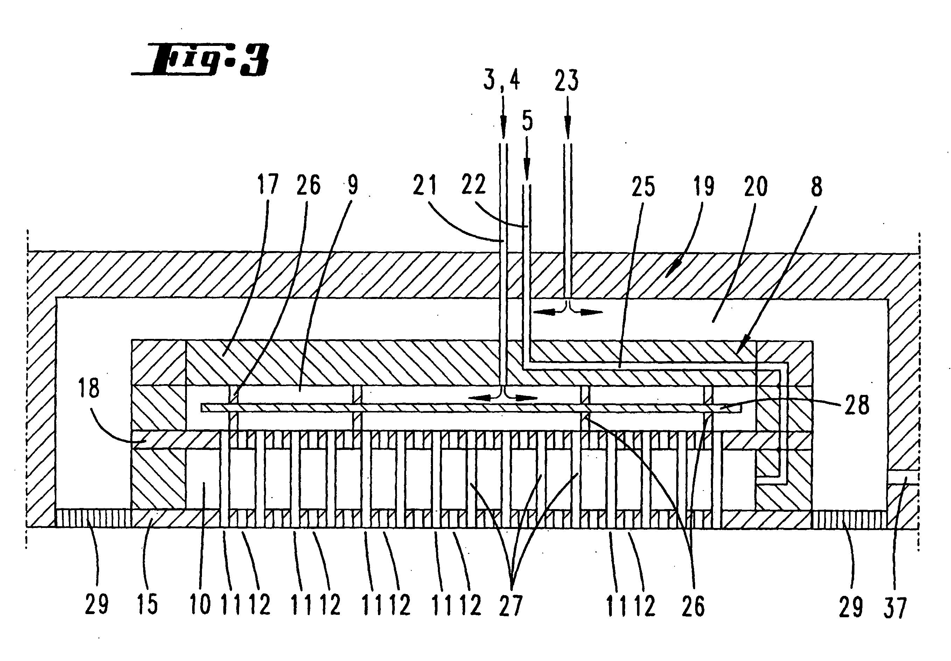

Bei der in Figur 3 dargestellten Gaseinlasseinheit besitzt das obere Puffervolumen 9 eine Zwischenplatte 28. Diese Zwischenplatte 28 kann ebenfalls mittels Brücken 26 mit der Deckplatte 17 verbunden sein. Es können auch Brücken 26 zur Verbindung der Zwischenplatte 28 mit der Zwischenplatte 18 vorgesehen sein. Die Zwischenplatte 18 hat zusätzlich die Funktion einer Prallwand. Gegen ihr Zentrum strömt der aus der Zuleitung 21 ausströmende Gasstrom und wird radial nach außen abgelenkt, um dort um die Randkante der Zwischenplatte 28 zu strömen und ebenfalls von außen nach innen in das Puffervolumen 9 zu treten.

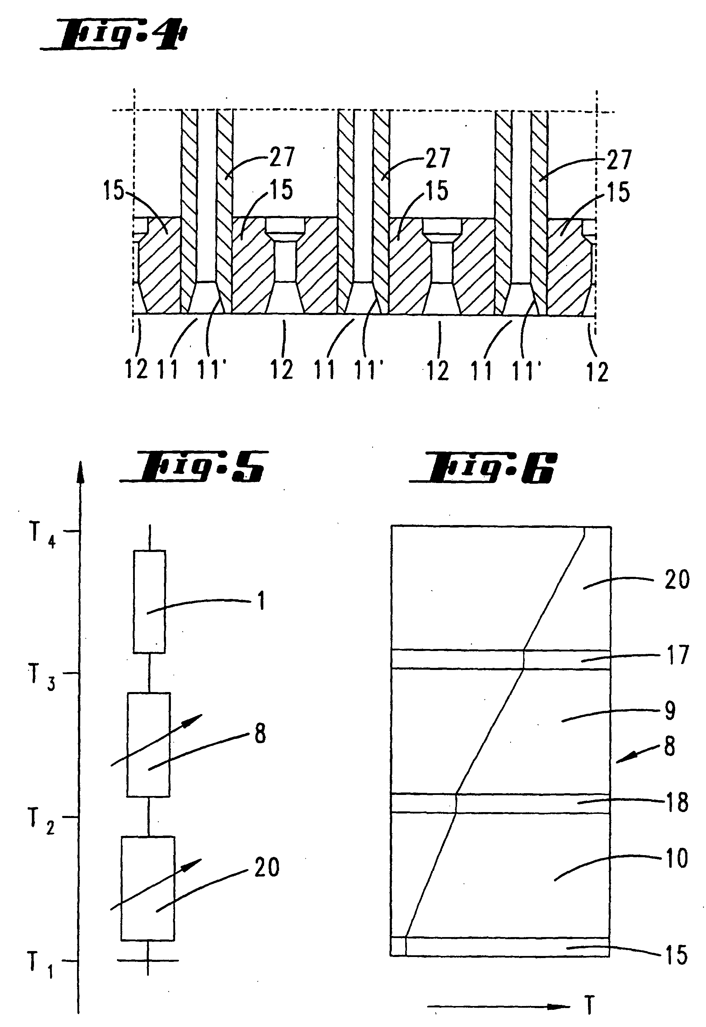

Die temperatursteuernde/regelnde Eigenschaft der zuvor beschriebenen Komponenten verdeutlicht die Figur 5. Die Wirkungsweise des Spaltraumes 20 ist hier als einstellbarer thermischer Widerstand dargestellt. Ebenso die Gaseinlasseinheit 8. An der in Figur 1 mit T¹ dargestellten Stelle, am Reaktordeckel 19, herrscht eine Temperatur T1, welche bspw. 1.000°C betragen kann. Die Temperatur T⁴, welche die Oberflächentemperatur des Substrates 2 ist, kann 200°C betragen. Diese beiden Temperaturen sind durch Heizen des Reaktordeckels 19 bzw. durch Heizen oder Kühlen des Suszeptors 14 voreinstellbar. Durch Verändern der Geometrien oder der Zusammensetzung bzw. des Druckes der Gase 23 im Spaltraum 20 oder Gase 3, 4, 5 bzw. 13 in den Puffervolumen 9, 10 können die Temperaturen T2, T3 also die Temperatur der Deckplatte 17 bzw. der Platte 15 eingestellt werden.

Ein Temperaturverlauf ist in Figur 6 dargestellt. An der Platte 15 herrscht eine geringe Temperatur von bspw. 400°C. An der Deckplatte 17 kann eine Temperatur von bspw. 800°C herrschen.

Bei einem anderen Prozess, der mit der zuvor beschriebenen Vorrichtung durchgeführt werden kann, besitzt das Substrat 2 durch geeignete Erwärmung mittels der Heizung 16 eine Temperatur die höher ist, als die Temperatur T1 der Reaktordecke, welche bspw. mittels Kühlung auf Raumtemperatur gehalten ist. Durch geeignete Wahl des Gases und dessen Drucks im Spaltraum 20 und durch Einstellung der Strömungsparameter bzw. der Geometrie in der Gaseinlasseinheit 8 können die Temperaturen T2 bzw. T3 eingeregelt werden. Handelt es sich bspw. bei den Reaktionsgasen um Gase, die oberhalb einer Reaktionstemperatur zerfallen, so werden die Parameter so eingestellt, dass die Temperatur in der diesem Gas zugeordneten Pufferkammer niedriger ist, als die Zerlegungstemperatur. Bei Reaktionsgasen, bei denen unterhalb einer Kondensationstemperatur eine Kondensation der Reaktionsgase zu erwarten ist, werden die entsprechenden Temperaturen in der Pufferkammer entsprechend hoch gehalten.

Die durch die Leitungen 21, 22 in die Gaseinlasseinheit eintretenden Gase werden durch die Gaseinlasseinheit 8 temperiert.

Bei dem in Figur 8 dargestellten Ausführungsbeispiel erfolgt die Temperierung mittels durch Kanäle 34, 35 oder 36 durchströmender Medien, bspw. Gase. Die Temperierung kann auch mittels eines Heizdrahtes erfolgen. Der Kanal 34 durchzieht die Lochplatte 15. Durch Kanal 34 kann ein kühlendes oder heizendes Medium fließen. Der Kanal 35 ist der Zwischenplatte 18 zugeordnet. Auch durch diesen Kanal kann ein kühlendes oder erwärmendes Medium fließen. Schließlich befindet sich auch in der Deckplatte 17 der Kanal 36, durch welchen ein ebensolches Medium fließen kann. In der Figur 8 sind die Kanäle 34, 35, 36 nur schematisiert dargestellt. Sie sind in den einzelnen Platten so angeordnet, dass die Platten gleichmäßig temperiert werden. Sie können bspw. die Platten mäanderförmig durchlaufen. Die Kanäle können als Bohrungen gestaltet sein, die jeweils endseitig miteinander verbunden sind. Es ist aber auch möglich, die Kanäle durch Nuten einzufräsen und durch eine Platte abzudecken, so dass die Platten 15, 18, 17 aus zwei aufeinander liegenden, miteinander verbundenen Platten bestehen. Die Gaseinlasseinheit 8 bzw. deren Platten sind dann als horizontale Mehrschichtstruktur gestaltet.

Um einen möglichst laminaren Austritt der Gase aus den Austrittsöffnungen 11, 12 zu gewährleisten, sind die Öffnungen trichterförmig aufgeweitet. Dies zeigt die Figur 4.

Bei dem in der Figur 7 dargestellten Aueführungsbeispiel kann die Gaseinlässeinheit entsprechend der Figur 3 oder der Figur 4 ausgestaltet sein. Bei diesem Ausführungsbeispiel befindet sich in dem Spaltraum 20 eine weitere Zwischenplatte in Form einer Prallplatte 30. Gegen diese Prallplatte 30 strömt das durch die Leitung 33 in den Spaltraum 20 eintretende Gas 23. Bei diesem Ausführungsbeispiel kann eine zusätzliche Gasleitung in den Spaltraum 20 führen. Diese Leitung 33' kann die Prallplatte 30 durchragen, so dass der aus der Leitung 33' austretende Gaestrom 23' gegen die Deckplatte 17 strömt.

Die in den Spaltraum 20 eingeleiteten Spülgase 23, 23' können vortemperiert sein.

## Patentansprüche

1. Verfahren zum Abscheiden ein oder mehrerer Schichten auf wenigstens einem in einer Reaktionskammer auf einem temperierten Suszeptor (14) angeordnetem Substrat, unter Verwendung mindestens eines flüssigen oder festen Ausgangsstoffes (3', 4') für zumindest eines der eingesetzten Reaktionsgase (3, 4) sowie gegebenenfalls wenigstens eines weiteren bei Raumtemperatur gasförmigen Reaktionsgases (6), bei dem der oder die flüssigen oder festen Ausgangsstoffe (3', 4') in einem oder mehreren Verdampfern (7) aus der flüssigen oder festen Phase direkt in die Dampfphase überführt werden, bevor sie in die Reaktionskammer (1) eintreten, wobei das oder die Reaktionsgase (1) in eine Gaseinlasseeinheit (8) eingelassen werden, die über eine Mehrzahl getrennter Gaswege (9,10), deren Zahl kleiner oder gleich der Zahl der verwendeten Reaktionsgase (3, 4, 5) ist, welche Gaswege eine Vielzahl von Austrittsöffnungen (11,12) verfügen, die so angeordnet sind, dass die verschiedenen Reaktionsgase (3,4,5) gleichmäßig über die Substratfläche verteilt eintreten, und dass das oder die Reaktionsgase auf ihrem jeweiligen Gasweg (9,10) durch die Gaseinlasseinheit (8) temperiert werden, wobei der Gaseinlasseinheit (8) auf ihrer dem Suszeptor (14) zugewandten Seite vom Suszeptor Wärme zu- oder abgeführt wird und anderseitig durch einen gasgespülten Spalt (20), dessen Wärmewiderstand durch Änderung der Gaszusammensetzung einstellbar ist, Wärme an eine Wärmesenke abgeführt oder von einer Wärmequelle zugeführt wird,
**dadurch gekennzeichnet dass**
- die Reaktionsgase (3,4,5) räumlich derart getrennt in die Reaktionskammer (1) eintreten, dass sie im Wesentlichen nicht vor der Oberfläche des oder der Substrate miteinander reagieren,
- bei einer gasdichten oder gedrosselten Abtrennung (29) des Spaltes (20) gegenüber der Reaktionskammer (1) der Wärmewiderstand des Spaltes (20) auch durch Änderung des Gasdrucks einstellbar ist und
- mittels mindestens einem der Gaseinlasseinheit zugeordneten, insbesondere von den Gaswegen (9,10) ausgebildeten Puffervolumen zwischen den beiden Seiten der Gaseinlasseinheit (8), durch Änderung des Drucks und/oder der Zusammensetzung des Gases (3, 4, 5) im Puffervolumen (9, 10) ein variabler Wärmewiderstand eingestellt wird.

2. Verfahren nach Anspruch 1 oder insbesondere danach, **dadurch gekennzeichnet, dass** die Temperatur der einzelnen Gase durch Einstellen des horizontalen und/oder des vertikalen Temperaturgradienten in der Gaseinlasseinheit (8) auf unterschiedliche Temperaturen gesteuert bzw. geregelt wird.

3. Verfahren nach einem oder mehreren der vorhergehenden Ansprüche oder insbesondere danach, **dadurch gekennzeichnet, dass** es sich bei dem Beschichtungsverfahren um ein CVD, MOCVD oder OVPD-Verfahren (Kondensationsbeschichtung) handelt.

4. Verfahren nach einem oder mehreren der vorhergehenden Ansprüche oder insbesondere danach, **dadurch gekennzeichnet, dass** es zur Herstellung von ein-, zwei- oder mehrkomponentigen Oxiden, die zur Gruppe oxidischer Materialien gehörender Perowskite oder geschichteter Perowskite wie z. B. BaSrTiO₃, PbZrTiO₃, SrBi₂Ta₂O₉ oder zur Herstellung organischer Schichten, insbesondere "small molecules" oder Polymere für bspw. Dünnfilmbauelemente wie OLED's, OTFT's oder Solarzellen dient.

5. Verfahren nach einem oder mehreren der vorhergehenden Ansprüche oder insbesondere danach, **dadurch gekennzeichnet dass** die Gaseinlasseinheit (8) auch zum Einlassen wenigstens eines Trägergases (13) und/oder eines Spülgases verwendet wird.

6. Vorrichtung zur Beschichtung eines Substrates (2) insbesondere unter Verwendung eines Verfahrens nach einem oder mehreren der vorhergehenden Ansprüche,
- mit einem Gasversorgungssystem (7), das mindestens zwei verschiedene Gase (3,4,5) bzw. Gasgemische getrennt bereitstellt,
- eine Reaktionskammer (8), in der mindestens ein zu beschichtendes Substrat (2) auf wenigstens einem beheiztem oder gekühltem Suszeptor (14) angeordnet ist,
- wenigstens einer temperierter Gaseinlasseinheit (8), die wenigstens zwei der Gase (3,4,5) bzw. Gasgemische über eine Mehrzahl von Gaswegen (9, 10) getrennt in die Reaktionskammer (1) einlässt und die eine Vielzahl von Gas-Austrittsöffnungen (11,12) aufweist,
- wobei die Gaseinlasseinheit (8) eine Platte (15) aufweist, in bzw. an der die Gas-Austritts-Öffnungen (11,12) vorgesehen sind,
- wobei die Platte (15) auf der dem Suszeptor (14) zugewandten Seite der Gaseinlasseinheit liegt und der Platte durch die Substrat- bzw. Suszeptor-Heizung (16) bzw. Kühlung und/oder das bzw. die beheizten bzw. gekühlten Substrate (2) bzw. Suszeptoren (14) direkt oder indirekt Wärme zu- oder abgeführt wird, und mit einem gasgespülten Spalt (20) zwischen der Gaseinlasseinheit und einer Wärmesenke oder Wärmequelle zur Wärmeab- oder zufuhr, wobei der Wärmewiderstand des Spaltes (20) durch Änderung der Gaszusammensetzung einstellbar ist,
**gekennzeichnet durch**
- eine Isolation oder Drossel (29) zwischen dem Spalt (20) und der Reaktionskammer (1), so dass der Wärmewiderstand des gasgespülten Spaltes (20) auch über den Gasdruck einstellbar ist und
- mindestens ein zwischen der Platte (15) und dem Spalt (20) angeordnetes, der Gaseinlasseinheit zugeordnetes, insbesondere von den Gaswegen (9, 10) ausgebildetes Puffervolumen, dessen Wärmewiderstand insbesondere **durch** Änderung des Drucks und/oder der Gaszusammensetzung des Gases (3,4,5) im Puffervolumen (9,10) einstellbar ist,
- wobei die Gas-Austrittsöffnungen (11/12) zu Gruppen zusammengefasst sind, deren Zahl der Zahl der getrennt einzulassenden Gase (3,4,5) bzw. Gasgemische entspricht, wobei aus jeder Gruppe von Gas-Austrittsöffnungen (11, 12) eines der Gase (3,4,5) bzw. Gasgemische in die Reaktionskammer austritt.

7. Vorrichtung nach einem oder mehreren der vorhergehenden Ansprüche oder insbesondere danach, **dadurch gekennzeichnet, dass** die Paffervolumen (9,10) in Normalrichtung der beheizten oder gekühlten Platte (15) übereinander in einem Gehäuse (15,17,18) der Gaseinlasseinheit (8) angeordnet sind.

8. Vorrichtung nach einem oder mehreren der vorhergehenden Ansprüche oder insbesondere danach, **dadurch gekennzeichnet, dass** die Wärmequelle (19) bzw. Wärmesenke ein temperiertes Teil des Reaktors und der Wärmesenke insbesondere ein gekühltes Teil des Reaktors ist und insbesondere der wassergekühlte oder geheizte Reaktordeckel (17) ist.

9. Vorrichtung nach einem oder mehreren der vorhergehenden Ansprüche oder insbesondere danach, **dadurch gekennzeichnet, dass** die Gaseinlasseinheit als horizontale oder vertikale Mehrschichtstruktur aus einem oder mehreren unterschiedlichen Materialien ausgerührt ist.

10. Vorrichtung nach einem oder mehreren der vorhergehenden Ansprüche oder insbesondere danach, **dadurch gekennzeichnet, dass** die Gaseinlasseinheit (8) mindestens eine Zwischenplatte (18) aufweist, die zur Einstellung des vertikalen und/oder horizontalen Temperaturgradienten an einander gegenüberliegende Begrenzungswände (15, 17) der Gaseinlasseinheit (8) thermisch angekoppelt (26, 28) ist.

11. Vorrichtung nach einem oder mehreren der vorhergehenden Ansprüche oder insbesondere danach, **dadurch gekennzeichnet, dass** wenigstens eine der Zwischenplatten (17) mindestens eine Öffnung aufweist.

12. Vorrichtung nach einem oder mehreren der vorhergehenden Ansprüche oder insbesondere danach, **dadurch gekennzeichnet, dass** wenigstens zwei der Zwischenplatten (18,28) über thermische Brücken (26,27) zur Einstellung des vertikalen, horizontalen und/oder radialen Wärmeflusses verbunden sind.

13. Vorrichtung nach einem oder mehreren der vorhergehenden Ansprüche oder insbesondere danach, **dadurch gekennzeichnet, dass** wenigstens eine der Zwischenplatten (28) zur Gasumlenkung innerhalb der Gaseinlasseinheit (8) dient.

14. Vorrichtung nach einem oder mehreren der vorhergehenden Ansprüche oder insbesondere danach, **dadurch gekennzeichnet, dass** wenigstens eine der Zwischenplatten außerhalb der Gaseinlasseinheit angeordnet ist und als Prallplatte dient.

15. Vorrichtung nach einem oder mehreren der vorhergehenden Ansprüche oder insbesondere danach, **dadurch gekennzeichnet, dass** die Zwischenplatten (18) die Pufferschicht (9,10) trennen.

16. Vorrichtung nach einem oder mehreren der vorhergehenden Ansprüche oder insbesondere danach, **dadurch gekennzeichnet, dass** in der Gasenlasseinheit (8) wenigstens ein Kanal (25) vorgesehen ist, der zur Einstellung des Temperaturgradienten in der Gaseinlasseinheit dient.

17. Vorrichtung nach einem oder mehreren der vorhergehenden Ansprüche oder insbesondere danach, **dadurch gekennzeichnet, dass** Röhrchen (26) die Gasaustrittsöffnungen mit den einzelnen Puffervolumen (9) verbinden.

## Claims

1. A process for depositing one or more layers on at least one substrate which is disposed on a temperature controlled susceptor (14) in a reaction chamber, using at least one liquid or solid starting material (3', 4') for at least one of the reaction gases (3, 4) used, and if appropriate at least one further reaction gas (6) which is in gas form at room temperature, in which process the liquid or solid starting material(s) (3', 4') are converted from the liquid or solid phase directly into the vapor phase in one or more evaporators (7) before they enter the reaction chamber (1), the reaction gas(es) (1) being admitted to a gas inlet unit (8), which has a plurality of separate gas paths (9, 10), the number of which is less than or equal to the number of reaction gases (3, 4, 5) used, which gas paths have a multiplicity of outlet openings (11, 12), which are disposed in such a way that the various reaction gases (3, 4, 5) enter the reaction chamber (1) distributed uniformly over the substrate area (2), and that the temperature of the reaction gas(es) on their respective gas path (9, 10) is controlled by the gas inlet unit (8), heat being supplied to or dissipated from the gas inlet unit (8) by the susceptor on the side of the gas inlet unit directed towards the susceptor (14), and, on the other side, heat is dissipated to a heat sink or supplied from a heat source through a gas purged gap (20), the heat resistance of which is adjustable by changing the gas composition,
**characterized in that**
- the reaction gases (3, 4, 5) enter the reaction chamber (1) spatially separate in such a manner that they substantially do not react with one another before reaching the surface of the substrate(s).
- for a sealing or throttling separation (29) of the gap (20) with respect to the reaction chamber (1), the heat resistance of the gap (20) is also adjustable by changing the gas pressure, and
- by means of at least one buffer volume between the two sides of the gas inlet unit (8), the buffer volume being associated with the gas inlet unit, and in particular formed by the gas paths (9, 10), a variable heat resistance is set by changing the pressure and/or the composition of the gases (3, 4, 5) in the buffer volume (9, 10).

2. The process according to claim 1 or in particular according thereto, **characterized in that** the temperature of the individual gases is controlled or regulated by setting the horizontal and/or vertical temperature gradient in the gas inlet unit (8) to different temperatures.

3. The process according to one or more of the preceding claims or in particular according thereto, **characterized in that** the coating process is a CVD, MOCVD or QVPD process (condensation coating).

4. The process according to one or more of the preceding claims or in particular according thereto, **characterized in that** it is used for the production of one-component, two-component or multicomponent oxides, the perovskites belonging to the group of oxide materials, or coated perovskites, such as for example BaSrTiO₃, PbZrTiO₃, SrBi₂Ta₂O₉, or for the production of organic layers, in particular small molecules or polymers for, for example, thin-film components, such as OLEDs, OTFTs or solar cells.

5. The process according to one or more of the preceding claims or in particular according thereto, **characterized in that** the gas inlet unit (8) is also used to admit at least one carrier gas (13) and/or a purge gas.

6. A device for coating a substrate (2), in particular using the process according to one or more of the preceding claims, having
- a gas supply system (7), which provides at least two different gases (3, 4, 5) or gas mixtures separately,
- a reaction chamber (8), in which at least one substrate (2) which is to be coated is disposed on at least one heated or cooled susceptor (14),
- at least one temperature-controlled gas inlet unit (8), which admits at least two of the gases (3, 4, 5) or gas mixtures separately into the reaction chamber (1) via a plurality of gas paths (9, 10), and which has a multiplicity of gas outlet openings (11, 12),
- the gas inlet unit (8) having a plate (15), in or at which the gas outlet openings (11, 12) are provided,
- the plate (15) being located on the side of the gas inlet unit directed towards the susceptor (14), and heat being directly or indirectly supplied to or dissipated from the plate by the substrate or susceptor heating (16) or cooling and/or by the heated or cooled substrate(s) (2, 14), and having a gas purged gap (20) between the gas inlet unit and a heat sink or heat source for dissipating or supplying heat, the heat resistance of the gap (20) being adjustable by changing the gas composition,
**characterized by**
- a separation or throttle (29) between the gap (20) and the reaction chamber (1), so that the heat resistance of the gas purged gap (20) is also adjustable via the gas pressure, and
- at least one buffer volume disposed between the plate (15) and the gap (20), the buffer volume being associated with the gas inlet unit and formed in particular by the gas paths (9, 10), the heat resistance of the buffer volume being adjustable in particular by changing the pressure and/or the gas composition of the gas (3, 4, 5) in the buffer volume (9, 10),
- the gas outlet openings (11/12) being combined in groups, the number of the groups corresponding to the number of the gases (3, 4, 5) or gas mixtures to be admitted separately, one of the gases (3, 4, 5) or gas mixtures exiting from each group of gas outlet openings (11, 12) into the reaction chamber.

7. The device according to one or more of the preceding claims or in particular according thereto, **characterized in that** the buffer volumes (9, 10), in the direction normal to the heated or cooled plate (15), are disposed above one another in a housing (15, 17, 18) of the gas inlet unit (8).

8. The device according to one or more of the preceding claims or in particular according thereto, **characterized in that** the heat source (19) or heat sink is a temperature-controlled part of the reactor, and the heat sink is in particular a cooled part of the reactor and in particular is the water-cooled or heated reactor cover (17).

9. The device according to one or more of the preceding claims or in particular according thereto, **characterized in that** the gas inlet unit is formed as a horizontal or vertical multilayer structure comprising one or more different materials.

10. The device according to one or more of the preceding claims or in particular according thereto, **characterized in that** the gas inlet unit (8) has at least one intermediate plate (18) which is thermally coupled (26, 28) to opposite boundary walls (15, 17) of the gas inlet unit (8) in order to set the vertical and/or horizontal temperature gradient.

11. The device according to one or more of the preceding claims or in particular according thereto, **characterized in that** at least one of the intermediate plates (17) has at least one opening.

12. The device according to one or more of the preceding claims or in particular according thereto, **characterized in that** at least two of the intermediate plates (18, 28) are connected via thermal bridges (26, 27) in order for the vertical, horizontal and/or radial heat flux to be set.

13. The device according to one or more of the preceding claims or in particular according thereto, **characterized in that** at least one of the intermediate plates (28) is used for gas diversion within the gas inlet unit (8).

14. The device according to one or more of the preceding claims or in particular according thereto, **characterized in that** at least one of the intermediate plates is disposed outside the gas inlet unit and serves as a baffle plate.

15. The device according to one or more of the preceding claims or in particular according thereto, **characterized in that** the intermediate plates (18) separate the buffer layer (9, 10).

16. The device according to one or more of the preceding claims or in particular according thereto, **characterized in that** in the gas inlet unit (8) there is at least one passage (25) which is used to set the temperature gradient in the gas inlet unit.

17. The device according to one or more of the preceding claims or in particular according thereto, **characterized in that** small tubes (26) connect the gas outlet openings to the individual buffer volumes (9).

## Revendications

1. Procédé pour séparer une ou plusieurs couches sur au moins un substrat agencé sur un suscepteur (14) tempéré dans une chambre de réaction, impliquant l'utilisation d'au moins une substance de base (ou matière premières) fluide ou solide (3', 4') pour au moins l'un des gaz de réaction utilisés (3, 4) ainsi que, le cas échéant, au moins un autre gaz de réaction (6) à l'état gazeux à température ambiante, pour lequel la ou les substance(s) de base (3', 4') fluide(s) ou solide(s) est ou sont directement convertie(s) en phase vapeur dans un ou plusieurs système(s) d'évaporation (7) à partir de la phase solide ou liquide, avant de pénétrer dans la chambre de réaction (1), le ou les gaz de réaction (1) étant admis dans un système d'admission du gaz (8), qui est doté de plusieurs conduites de gaz séparées (9, 10) dont le nombre est inférieur ou égal au nombre de gaz de réaction utilisés (3, 4, 5), lesquelles conduites de gaz disposent d'une multitude d'orifices de sortie (11, 12) qui sont agencés de telle sorte que les différents gaz de réaction (3, 4, 5) arrivent de manière séparée et régulière sur la surface du substrat et que le ou les gaz de réactions soi(en)t tempéré(s) par le système d'admission du gaz (8) sur leur conduite de gaz respective (9, 10), le système d'admission du gaz (8) étant alimenté en chaleur ou purgé de celle-ci par le suscepteur au niveau de la face dudit système orientée vers le suscepteur (14) et par ailleurs, la chaleur est amenée depuis une source de chaleur ou elle est évacuée au niveau d'un puit thermique au moyen d'un volume intercalaire balayé par un au gaz (20), dont la résistance thermique est réglable au moyen des modifications de composition gazeuse,
**caractérisé de ce que :**
- les gaz de réaction (3, 4, 5) pénètrent en effet dans la chambre de réaction (1) de façon séparée en termes d'espace, de sorte qu'ils ne réagissent pas notablement les uns avec les autres avant d'avoir atteint la surface du ou des substrat(s),
- la résistance thermique du volume intercalaire (20) est également réglable par la pression gazeuse ou une séparation étranglée (29) de la colonne (20) par rapport à la chambre de réaction (1) ou par variation de la pression gazeuse et
- une résistance thermique variable est réglée par une modification de la pression et / ou de la composition d'au moins un gaz (3, 4, 5) au sein des conduites de gaz (9, 10) au moyen d'au moins un volume tampon formé notamment par les conduites de gaz (9, 10), alloué au système d'admission du gaz et situé entre les deux côtés du système d'admission du gaz (8).

2. Procédé selon la revendication 1 **caractérisé en ce que** la température des différents gaz est régulée ou contrôlée sur diverses températures par le réglage du gradient de température vertical et / ou horizontal au sein du système d'admission du gaz (8).

3. Procédé selon l'une quelconque ou plusieurs des revendications précédentes, **caractérisé en ce qu'**il s'agit quant au procédé de revêtements d'un procédé de dépôt chimique en phase vapeur, de MOCVD, ou de OVPD dépôt en phase vapeur organique (revêtement par condensation).

4. Procédé selon l'une quelconque ou plusieurs des revendications précédentes, **caractérisé en ce qu'**on utilise, pour la production d'oxydes unicomposants, bicomposants ou multicomposants, la pérowskite ou la pérowskite en couche appartenant au groupe des matières oxydantes telles que par exemple BaSrTiO₃, PbZrTiO₃, SrBi₂Ta₂O₉, ou, pour la fabrication des couches organiques, des molécules de petite taille notamment ou des polymères destinés par exemple aux composants à couche mince tels que les OLED ou les transistors organiques à couche mince (OTFT) ou les piles solaires.

5. Procédé selon l'une quelconque ou plusieurs des revendications précédentes, **caractérisé en ce que** le système d'admission des gaz (8) est également utilisé pour l'admission d'au moins un gaz porteur (13) et / ou d'un gaz de rinçage ou balayage.

6. Dispositif pour déposer un revêtement sur un substrat (2) en particulier en utilisant un procédé selon l'une quelconque ou plusieurs des revendications précédentes,
- comportant un système d'alimentation en gaz (7), qui fournit séparément au moins deux gaz différents (3, 4, 5) ou mélanges de gaz,
- une chambre de réaction (8), dans laquelle au moins un substrat à recouvrir est disposé sur au moins un suscepteur (14) chauffé ou refroidi,
- au moins un système d'admission de gaz tempéré (8), qui laisse pénétrer séparément au moins deux gaz (3, 4, 5) ou des mélanges gazeux par l'intermédiaire d'une multiplicité des conduites de gaz (9, 10) dans la chambre de réaction (1) et qui présente une multiplicité d'orifices de sortie du gaz (11, 12),
- le système d'admission du gaz (8) présentant une plaque (15), dans laquelle ou au niveau de laquelle les orifices de sortie du gaz (11, 12) sont prévus,
- la plaque (15) se trouvant sur la face orientée vers le suscepteur (14) du système d'admission du gaz et la plaque étant alimentée ou purgée de chaleur par l'intermédiaire du chauffage ou refroidisseur (16) du substrat ou du suscepteur ou de leur refroidissement et / ou le ou les substrats (2) ou suscepteur(s) (14) chauffé(s) ou refroidi(s) étant alimenté(s) ou purgé(s) de chaleur de façon directe ou indirecte, et à l'aide d'un volume balayé au gaz (20) située entre le système d'admission du gaz et un puits thermique ou une source thermique pour l'apport ou l'évacuation de la chaleur, la résistance thermique du volume (20) étant réglable par variation de la composition gazeuse,
**caractérisé par**
- une isolation ou une restriction (29) située entre le volume (20) et la chambre de réaction (1) de telle sorte que la résistance thermique du volume balayé au gaz (20) puisse être également réglée par la pression du gaz et
- au moins un volume tampon formé notamment par les conduites de gaz (9, 10) alloué au système d'admission du gaz et agencé entre la plaque (15) et le volume (20), dont la résistance thermique peut être réglée notamment en modifiant la pression et / ou la composition gazeuse du gaz (3, 4, 5) au sein du volume tampon (9, 10),
- les orifices de sortie du gaz (11/12) étant réunis par groupes, dont le nombre correspond au nombre de gaz (3, 4, 5) ou de mélanges gazeux devant pénétrer séparément, un des gaz (3, 4, 5) ou mélanges gazeux pénétrant dans la chambre de réaction à partir de chaque groupe d'orifices de sortie du gaz (11, 12).

7. Dispositif selon l'une quelconque ou plusieurs des revendications précédentes, **caractérisé en ce que** les volumes tampon (9, 10) sont agencés de façon superposée dans le sens normal par rapport à la plaque chauffée ou refroidie (15) au sein d'un compartiment (15, 17, 18) du système d'admission des gaz (8).

8. Dispositif selon l'une quelconque ou plusieurs des revendications précédentes, **caractérisé en ce que** la source thermique (19) ou le puits thermique représente un élément tempéré du réacteur et le puits thermique représente notamment un élément refroidi du réacteur et est notamment le couvercle du réacteur (17) chauffé ou refroidi par circulation d'eau.

9. Dispositif selon l'une quelconque ou plusieurs des revendications précédentes, **caractérisé en ce que** le système d'admission du gaz est réalisé en tant que structure multicouche verticale ou horizontale à partir d'un ou plusieurs matériaux différents.

10. Dispositif selon l'une quelconque ou plusieurs des revendications précédentes, **caractérisé en ce que** le système d'admission du gaz (8) présente au moins une plaque intermédiaire (18), laquelle est couplée (26, 28) thermiquement avec les parois (15, 17) de délimitation du système d'admission du gaz (8) faisant face l'une à l'autre pour le réglage du gradient de température vertical ou horizontal.

11. Dispositif selon l'une quelconque ou plusieurs des revendications précédentes, **caractérisé en ce qu'**au moins une des plaques intermédiaires (17) présente au moins une ouverture.

12. Dispositif selon l'une quelconque ou plusieurs des revendications précédentes, **caractérisé en ce qu'**au moins deux des plaques intermédiaires (18, 28) sont reliées par des ponts thermiques (26, 27) pour le réglage du flux thermique radial, horizontale et / ou verticale.

13. Dispositif selon l'une quelconque ou plusieurs des revendications précédentes, **caractérisé en ce qu'**au moins une des plaques intermédiaires (28) sert pour le retour gazeux au sein du système d'admission du gaz (8).

14. Dispositif selon l'une quelconque ou plusieurs des revendications précédentes, **caractérisé en ce qu'**au moins une plaque intermédiaire est agencée à l'extérieur du système d'admission du gaz et sert de plaque de déviation.

15. Dispositif selon l'une quelconque ou plusieurs des revendications précédentes, **caractérisé en ce que** les plaques intermédiaires (18) séparent la couche de tampon (9, 10).

16. Dispositif selon l'une quelconque ou plusieurs des revendications précédentes, **caractérisé en ce qu'**au moins un canal (25) est prévu dans le système d'admission du gaz (8), lequel canal sert pour le réglage des gradients de température dans le système d'admission du gaz.

17. Dispositif selon l'une quelconque ou plusieurs des revendications précédentes, **caractérisé en ce que** les tubulures (26) relient les orifices de sortie du gaz avec chacune des volumes tampons (9).
